(19) **Europäisches Patentamt**
**European Patent Office**
**Office européen des brevets**

(11) **EP 4 761 281 A1**

(12) **EUROPEAN PATENT APPLICATION**

(43) Date of publication:
**17.06.2026 Bulletin 2026/25**

(21) Application number: **25218596.2**

(22) Date of filing: **26.11.2025**

(51) International Patent Classification (IPC):
*H04R 3/00* (2006.01)    *H04R 3/04* (2006.01)
*H03G 5/00* (2006.01)    *H03G 5/02* (2006.01)
*H03G 5/16* (2006.01)

(52) Cooperative Patent Classification (CPC):
**H04R 3/04; H03G 5/005; H03G 5/025; H03G 5/165; H03G 9/025; H04R 3/00;** H04R 2430/03

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **10.12.2024 US 202418975789**

(71) Applicant: **Harman Becker Automotive Systems GmbH**
**76307 Karlsbad (DE)**

(72) Inventor: **SABADE, Praveen**
**76307 Karlsbad (DE)**

(74) Representative: **Westphal, Mussgnug & Partner, Patentanwälte mbB**
**Werinherstraße 79**
**81541 München (DE)**

(54) **TECHNIQUES FOR AUTOMATIC EQUALIZATION OF AUDIO**

(57)    In various embodiments, the disclosed techniques automatically change the audio equalization levels of audio content. When an audio content is requested for playback, the equalization manager of an audio system extracts the frequency components of a segment of the audio content. The equalization manager analyzes the frequency components of the segment and separates the frequency components into predefined frequency bands based on the analysis. The equalization manager determines sound pressure level (SPL) metrics of each frequency component. The equalization manager generates a custom equalization setting using gains calculated for each frequency band based on the SPL metrics. The equalization manager then adjusts the audio segment by applying the custom equalization setting to generate a modified segment (e.g., applying the calculated gains to each of the frequency bands). The modified segment is then output as audio to a user. The process then repeats for additional segments of the audio.

**FIG. 4**

**EP 4 761 281 A1**

Description

## BACKGROUND

**Field of the Various Embodiments**

The various embodiments relate generally to audio processing, more specifically, to techniques for automatic equalization of audio.

**Description of the Related Art**

Audio systems, such as audio systems in vehicles, are no longer simply equipped with radios that have a single dial to change the radio station. Instead, state of the art audio systems provide custom audio experiences in numerous listening environments (e.g., listening environments within vehicles) not only provide more options than traditional radios or other audio playback options, but also include custom audio equalization settings to provide a better listening experience. Audio equalization is the process of adjusting the volume of different frequency bands within an audio signal to provide a better listening experience.

One approach for audio equalization is to provide options to change the equalization settings. Equalization settings refer to the volume of the audio across the frequency bands, such as the Bass, Mid, and Treble (BMT) frequency bands. The Bass band has a frequency range of approximately 20Hz - 300Hz, Mid band has a frequency range of approximately 301Hz - 2,000Hz, and Treble band has a frequency range of approximately 2,001Hz - 20,000Hz. However, frequency bands can be divided into smaller sub bands. Depending on the acoustic composition of the audio, such as the musical instruments used in a song, the ideal equalization of each frequency band to provide an optimal listening experience may differ. For example, songs in the Rock and Roll genre often contain kick drums and bass guitar, which produce audio signals with significant content in the Bass frequency band, but also include crisp vocals and cymbals, which produce audio signals with content in the Treble frequency band. Due to the musical instrument makeup, most people find the optimal equalization settings for Rock and Roll include increasing the gain of the Bass and Treble frequency bands while lowering the gain of the Mid frequency band. Currently, audio systems, (e.g., head units in vehicles) provide various equalization settings that a user can manually customize to suit the need of the audio being played. Additionally, some audio systems provide default equalization settings based on various genres of music, such as a Rock setting, a Jazz setting, a Pop music setting, and/or others.

One drawback of both manually customizing the equalization settings and changing the default equalization settings to a different genre is that it can be a distraction to the user, especially the driver of a vehicle. Drivers need to be focused on driving and not the equalization settings of the audio being played. Moreover, changing the equalization settings prior to driving does not necessarily solve the driving distraction problem. For example, audio playlists and/or radio stations that feature multiple genres can require constant equalization settings changes after each song for an optimal listening experience.

Furthermore, another drawback to manually customizing the equalization settings is that manual customization requires knowledge of both the musical accompaniment of the audio and the underlying audio engineering to properly understand which frequency bands should be raised or lowered based on the audio being played. Additionally, another drawback of using default equalization settings is the limited options of equalization settings available to choose from. For example, less popular music genres, such as classical, might not have a custom equalization setting available.

As the foregoing illustrates, what is needed in the art is more effective techniques for automatically updating audio equalization levels.

## SUMMARY

In various embodiments, a computer-implemented method for automatically updating equalization settings of audio segments comprises: receiving audio content for playback; extracting a plurality of frequency components from a first segment of the audio content; separating the plurality of frequency components into a plurality of first frequency bands; determining a sound pressure level (SPL) for each frequency component in the plurality of frequency components; determining, based on the SPL of each frequency component in the plurality of frequency components, a gain for each frequency band in the plurality of first frequency bands; generating, based on the gain for each frequency band in the plurality of first frequency bands, a first equalization setting; adjusting, based on the first equalization setting, the first segment to generate a modified segment; and outputting the modified segment using one or more speakers.

At least one technical advantage of the disclosed techniques relative to the prior art is that the disclosed techniques allow for automatically changing audio equalization levels based on the content of the audio being played. By automatically changing the audio equalization levels, users (e.g., the drivers of vehicles) no longer have an extra distraction while still being able to have a quality listening experience. Furthermore, because the change in equalization levels is automatic and not manual, users do not need an extensive knowledge of the musical composition of the audio and/or underlying audio engineering is not required. Additionally, because the audio equalization levels change based on the audio being played, the audio system is not restricted to a few default equalization settings that might not encompass the desired breadth of audio being played. These technical advantages provide one or more technological improvements over prior art approaches.

## BRIEF DESCRIPTION OF THE DRAWINGS

So that the manner in which the above recited features of the various embodiments can be understood in detail, a more particular description of the inventive concepts, briefly summarized above, may be had by reference to various embodiments, some of which are illustrated in the appended drawings. It is to be noted, however, that the appended drawings illustrate only typical embodiments of the inventive concepts and are therefore not to be considered limiting of scope in any way, and that there are other equally effective embodiments.

Figure 1 is a conceptual illustration of a computer system configured to implement one or more aspects of the various embodiments;

Figure 2 is a conceptual illustration of a block diagram of the equalization manager of Figure 1, according to various embodiments;

Figure 3 is a conceptual illustration of an exemplary frequency spectrum of an audio segment, according to various embodiments; and

Figure 4 is flowchart of method steps for automatically updating equalization settings, according to various embodiments.

## DETAILED DESCRIPTION

In the following description, numerous specific details are set forth to provide a more thorough understanding of the various embodiments. However, it will be apparent to one of skilled in the art that the inventive concepts may be practiced without one or more of these specific details.

### System Overview

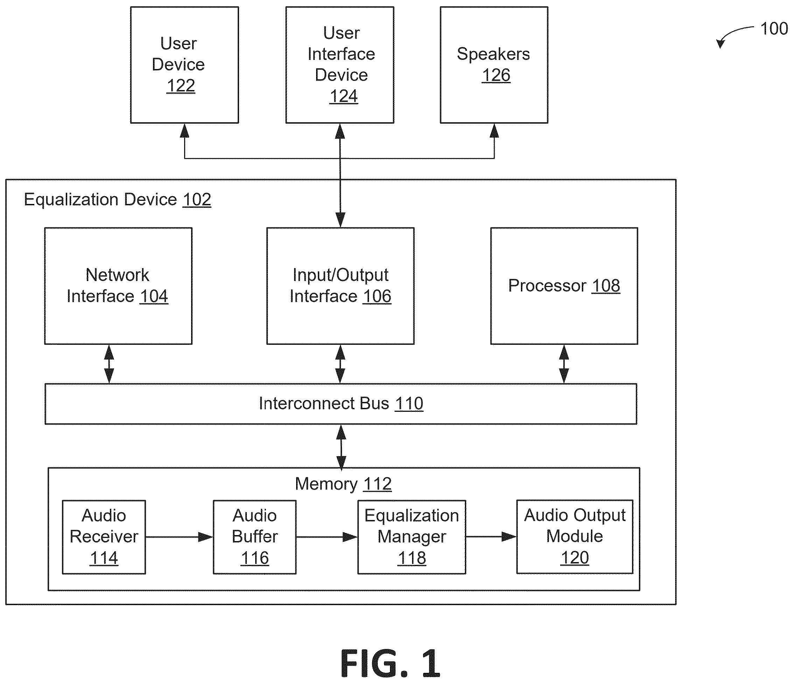

Figure 1 illustrates a block diagram of a computer system 100 configured to implement one or more aspects of the various embodiments. As shown, system 100 includes, without limitation, an equalization device 102, user device 122, user interface device 124, and speakers 126. As shown, equalization device 102 includes, without limitation, a network interface 104, an input/output interface 106, a processor 108, an interconnect bus 110, and a memory 112. As shown, memory 112 includes, without limitation, an audio receiver 114, an audio buffer 116, an equalization manager 118, and an audio output module 120.

System 100 is shown herein for illustrative purposes only, and variations and modifications are possible without departing from the scope of the present disclosure. For example, system 100 can include multiple instances of elements, such as multiple equalization devices, user devices, display devices, and/or speakers, even when not shown, and still be within the scope of the disclosed embodiments. Further, the connection topology between the various units in Figure 1 can be modified as desired. In some embodiments, any combination of equalization device 102, user device 122, and user interface device 124 can be included in and/or replaced with any type of virtual computing system, distributed computing system, and/or cloud computing environment, such as a public, private, or a hybrid cloud system.

Equalization device 102 is an audio processing device, such as a vehicle audio system, a home theater system, sound system, and/or similar system/device. For example, equalization device 102 can be included in one or more devices, such as consumer products (e.g., portable speakers, gaming, etc. products), vehicles (e.g., the head unit of a car, truck, van, etc.), smart home devices (e.g., smart lighting systems, security systems, digital assistants, etc.), communications systems (e.g., conference call systems, video conferencing systems, speaker amplification systems, etc.), mobile devices (e.g., smart phones, tablets, etc.), computers, and so forth. In various embodiments, equalization device 102 is located in various acoustic environments including, without limitation, vehicles, indoor environments (e.g., living room, conference room, conference hall, home office, etc.), and/or outdoor environments, (e.g., patio, rooftop, garden, etc.). Equalization device 102 is configured to receive audio content and output the audio content adjusted with customized equalization settings. The audio content can be streamed audio data in any technically feasible audio format.

For example, user device 122 can send a stream of audio data, such as a song from a streaming application, radio application, musical library, or any other source of audio streaming. The audio content can be compressed audio data. The audio content can be received segment by segment. The equalization settings can be configured automatically upon receiving the audio content without a user manually changing the equalization settings.

In some embodiments, equalization device 102 is configured with various settings. One setting of the equalization device 102 can be to analyze a first segment of the audio content to determine a custom equalization setting and then use the same custom equalization settings for each other audio segment of the audio content. For example, a user of user device 122 or user interface device 124 may want a custom equalization setting determined for a particular song but does not want the equalization to change after the song is output with the custom equalization setting. Another setting of equalization device 102 can be to analyze each segment of the audio content to determine a custom equalization setting for each segment of the audio content. Another setting of equalization device 102 can be to use a default equalization setting for at least a portion of the audio content until equalization device 102 determines a custom equalization setting for a segment of audio content. The various settings of equalization device 102 are not meant to be limiting in any way and can be determined by user device 122, user interface device 124, or any combination of the above.

Network interface 104 is configured to transmit and receive audio content from a network (not shown). In some embodiments, network interface 104 is configured to communicate using an Ethernet Network, a Bluetooth® network, a wireless network, or any other technically feasible network for communicating audio data. Network interface 104 communicates with processor 108, input/output interface 106, and memory 112 via interconnect bus 110.

Processor 108 is configured to read and write data from memory 112. Processor 108 is configured to retrieve and execute programming instructions, such as audio receiver 114, audio buffer 116, and equalization manager 118, stored in memory 112. Similarly, processor 108 is configured to store application data (e.g., software libraries) and retrieve application data from memory 112. Processor 108 can be any suitable processor, such as a central processing unit (CPU), a graphics processing unit (GPU), an application-specific integrated circuit (ASIC), a field programmable gate array (FPGA), a digital signal processor (DSP), and/or any other type of processing unit, or a combination of processing units, such as a CPU configured to operate in conjunction with a GPU. In general, processor 108 can be any technically feasible hardware unit capable of processing data and/or executing software applications.

Interconnect bus 110 is configured to facilitate transmission of data, such as programming instructions, application data, audio and/or video data, and other data, between network interface 104, input/output interface 106, processor 108, memory 112, and any other components of equalization device 102. Other aspects of equalization device 102 not shown can also communicate with each other aspect of equalization device 102 using interconnect bus 110.

Memory 112 can include a random-access memory (RAM) module, a flash memory unit, or any other type of memory unit or combination thereof. In various embodiments, memory 112 includes non-volatile memory, such as optical drives, magnetic drives, flash drives, or other storage. In some embodiments, separate data stores, such as an external included in a network ("cloud storage") (not shown) can supplement the memory 112. Audio receiver 114, audio buffer 116, and equalization manager 118 within memory 112 can be executed by processor 108 to implement the overall functionality of equalization device 102 and, thus, to coordinate the operation of the system 100 as a whole.

Audio receiver 114 is configured to receive audio content from a user device, such as user device 122, via the input/output interface 106 or from a network (not shown) via network interface 104. For example, audio receiver 114 is configured to perform simple audio tuning, such as adjusting the distortion of the audio content or maximizing intelligibility, to improve the listening quality of the audio content. In some embodiments, audio receiver 114 can be configured to tune, decode, and/or decompress the received audio content. For example, audio receiver 114 can be any technically feasible audio codec or audio decoder that is configured to decode and/or decompress the compressed audio content received at equalization device 102. Incoming compressed audio content can be decoded by audio receiver 114 into raw pulse-code-modulation (PCM) segments using any technically feasible decompression technique, such as modified discrete cosine transform (MDCT) coding and linear predictive coding (LPC). Audio decoder supports any audio format, such as such as MPEG-1 Audio Layer III (MP3), waveform (WAV), advanced audio coding (AAC), or any other technically feasible audio format. After decompression, audio receiver 114 can send (e.g., push) the decoded audio segments to audio buffer 116.

Audio buffer 116 can be a first-in first-out (FIFO) buffer. Audio buffer 116 can be implemented, without limitation, as a single buffer, double buffer, circular buffer, array buffer, ring buffer, vertex buffer, constant buffer, or any other technically feasible type of buffer. In some embodiments, audio buffer 116 includes a write pointer and read pointer (not shown) that reference locations in the memory of audio buffer 116 where one or more audio segments are stored. When an audio segment is written (e.g., pushed) to the audio buffer 116, the audio segment is stored at a next available location. For example, audio receiver 114 can push one or more audio segments to audio buffer 116 after decoding the received audio content. The one or more audio segments can be stored in memory of audio buffer 116 one at a time at the next available location within audio buffer 116. If equalization device 102 receives audio content that does not need to be decoded and/or decompressed by audio receiver 114, audio receiver 114 can still perform simple audio tuning, such as adjusting the distortion of the audio content or maximizing intelligibility, before pushing the received audio content to audio buffer 116. When an audio segment is read (e.g., popped) from audio buffer 116 by equalization manager 118, audio buffer 116 retrieves the oldest audio segment from memory and provides the data packet to equalization manager 118. When audio buffer 116 does not have an audio segment that can be read, audio buffer 116 indicates that audio buffer 116 is empty.

Equalization manager 118 is configured to receive audio segments from audio buffer 116. Equalization manager 118 is configured to extract frequency components of the audio segments. Equalization manager 118 can extract frequency components of the audio using any technically feasible method, such as inverse DCT (IDCT). IDCT converts signals in the time domain into signals in the frequency domain. For example, a frequency component can correspond to any sub-range of frequencies from 20Hz to 20kHz within the frequency domain. Equalization manager 118 separates the extracted frequency components into different frequency bands. For example, equalization manager 118 can separate the frequency components into nine frequency bands, where band 1 ranges from 0Hz - 40Hz, band 2 ranges from 41Hz - 90Hz, band 3 ranges from 91Hz - 190Hz, band 4 ranges from 191Hz - 320Hz, band 5 ranges from 321Hz - 750Hz, band 6 ranges from 751Hz - 1.2kHz, band 7 ranges from 1.2kHz - 2.5kHz, band 8 ranges from 2.5kHz - 5kHz, and band 9 ranges from 5kHz - 10kH. Equalization manager 118 can use any number of ranges, sub-ranges, and/or bands as necessary and the example above is not meant to be limiting in any way. Equalization manager 118 calculates the sound pressure level (SPL) of each frequency component belonging to the different frequency bands. The SPL can be calculated using any technically feasible algorithm, such as Equation 1 below,

$$Lp=10lg\ (p/p_0)^2 \qquad\qquad (1)$$

where p is the sound pressure in pascals and $p_0$ is a reference pressure (e.g., 20 micro pascal). Once the SPL of each frequency band is calculated, equalization manager 118 determines the highest SPL among the frequency components, the lowest SPL among the frequency components, and the delta between the highest SPL and lowest SPL. Equalization manager 118 calculates the gain for each frequency band using any technically feasible algorithm, such as Equation 2 below,

$$Gain[band] = SPL[band] - HighestSPL + DeltaSPL \qquad\qquad (2)$$

Equalization manager 118 sends the calculated gains, the corresponding frequency components, and the audio segment to audio output module 120. Equalization manager 118 continues calculating the gain for each frequency band for each audio segment received from audio buffer 116, thereby allowing each audio segment to have a customized equalization setting. For example, the audio content received by equalization device 102 can be streamed audio data, such as a song. Songs with varying musical instruments can require different equalization settings at different parts of the song in order to provide the best quality listening experience. By breaking up the audio content into segments and calculating the gains of each frequency band for each segment, equalization manager 118 automatically provides the gains for each frequency band to best suit each part of the song.

Equalization manager 118 generates a custom equalization setting for the audio segment based on the gains. In some embodiments, the custom equalization setting can be a best-fit setting. For example, equalization manager 118 can determine from a set of pre-defined equalization settings, such as default Bass, Mid, Treble (BMT) settings, of an audio system, such as a vehicle sound system, a closest matching pre-defined equalization setting. The closest matching pre-defined equalization setting is the equalization setting in the set of pre-defined equalization settings whose frequency bands most closely matches the frequency bands associated with the frequency components of the audio segment once the determined gains are applied.

Audio output module 120 is configured to receive the gains calculated by equalization manager 118, the corresponding frequency components, and the audio segment from equalization manager 118. Gain is the amount of amplification applied to an audio signal. Adjusting the gain of a frequency band includes raising or lowering the amplitude of the portion (e.g., frequency components) of the audio segment that corresponds to the frequency band. Audio output module 120 adjusts the audio segment by applying the custom equalization setting (e.g., applying the calculated gains to each of the frequency bands determined by the equalization manager 118).

The custom equalization setting is used during output of the audio segment to provide a better-quality listening experience. The audio output module 120 outputs the audio segment adjusted by the custom equalization setting to speakers 126 via input/output interface 106. A notification when the custom equalization setting changes can be displayed by user interface device 124 via input/output interface 106. In some embodiments, audio output module 120 can delay the output of the audio segment for a pre-defined amount of time, such as 30 seconds, to allow for the next segment of audio to analyzed by equalization device 102.

User device 122 can be a desktop computer, a laptop computer, a smart phone, a personal digital assistant (PDA), tablet computer, or any other type of computing device configured to send audio content to equalization device 102 via input/output interface 106. A user device of user device(s) 122 connected to equalization device 102 can send a request to equalization device 102 to output audio content via speaker 126. In some embodiments, user device 122 is configured to control one or more settings of equalization device 102, such as whether to automatically equalize audio content, how often to change the equalization settings, whether to delay a change in equalization settings, or any other technically feasible setting regarding the equalization settings.

User interface device 124 can be any device that is capable of displaying an image and/or any other type of visual content. For example, the user interface device 124 could be, without limitation, a Heads-Up-Display (HUD) in a vehicle, a liquid crystal display, a light-emitting diode display, a projection display, a plasma display panel, etc. In some embodiments, the user interface device 124 is a touchscreen that is capable of displaying visual content and receiving input (e.g., from a user). For example, user interface device 124 can be configured to display the information associated with the audio content, such as the name of the audio content, equalization settings, and other options to interact with the audio content. In some embodiments user interface device 124 and user device 122 are the same device. User interface device 124 can be connected to equalization device 102 via input/output interface 106. In some embodiments, user interface device 124 is configured to control one or more settings of equalization device 102, such as whether to automatically equalize audio content, how often to change the equalization settings, whether to delay a change in equalization settings, or any other technically feasible setting regarding the equalization settings.

Speakers 126 can be any technically feasible device capable of broadcasting or otherwise transmitting audio signals, such as the audio signals associated with the audio content. Speakers 126 can include, without limitation a soundbar with multiple speaker units, one or more loudspeakers, or any other speaker system that reproduces one or more audio signals by generating soundwaves. Speakers 126 can be connected to equalization device 102 via input/output interface 106. Speakers 126 can include one or more wired speakers and/or one or more wireless speakers.

**Calculating Equalization Gains**

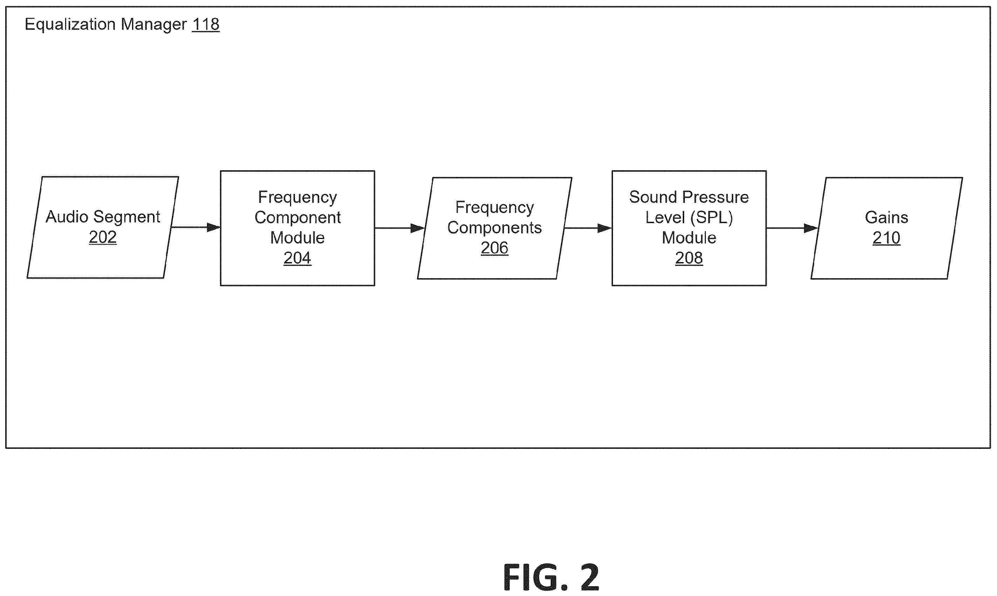

Figure 2 illustrates a block diagram of equalization manager 118 according to various embodiments. As shown, equalization manager 118 includes, without limitation, a frequency component module 204, frequency components 206, and an SPL module 208. Equalization manager 118 receives audio segment 202 and outputs gains 210.

Equalization manager 118 is configured to receive audio segment 202 from an audio source, such as audio buffer 116 of Figure 1. Audio segment 202 can be a segment of streamed audio content, over the air content, and/or any other audio source. Audio content 202 can be a segment of a song. Equalization manager 118 sends audio segment 202 to frequency component module 204 to extract the frequency components from audio segment 202.

Frequency component module 204 is configured to extract frequency components 206 of audio segment 202. Frequency component module 204 extracts frequency components 206 of the audio segment using any technically feasible method, such as IDCT. IDCT converts signals in the time domain into signals in the frequency domain. For example, a frequency component can correspond to any sub-range of frequencies from 0Hz to 20kHz within the frequency domain. Frequency component module 204 separates the extracted frequency components 206 into different frequency bands, such as frequency components 206. For example, frequency component module 204 can separate the frequency components 206 into nine frequency bands, where band 1 ranges from 0Hz - 40Hz, band 2 ranges from 41Hz - 90Hz, band 3 ranges from 91Hz - 190Hz, band 4 ranges from 191Hz - 320Hz, band 5 ranges from 321Hz - 750Hz, band 6 ranges from 751Hz - 1.2kHz, band 7 ranges from 1.2kHz - 2.5kHz, band 8 ranges from 2.5kHz - 5kHz, and band 9 ranges from 5kHz - 10kHz. Frequency component module 204 can use any number of ranges, sub-ranges, and/or bands as necessary and the example above is not meant to be limiting in any way. Equalization manager 118 sends frequency components 206 to SPL module 208 to calculate the SPL for each frequency component belonging to the different frequency bands.

SPL module 208 calculates the SPL of each frequency component in frequency components 206 belonging to the different frequency bands. The SPL can be calculated using any technically feasible algorithm, such as Equation 1 above. Once the SPL of each frequency component in frequency components 206 is calculated, SPL module 208 determines the highest SPL among frequency components 206, the lowest SPL among frequency components 206, and the delta between the highest SPL and lowest SPL. SPL module 208 calculates the gain for each frequency component in frequency components using any technically feasible algorithm, such as Equation 2 above. As a result, SPL module 208 generates gains 210 representing the gain to be applied to each frequency band associated with the frequency components 206 of the audio segment. Gain is the amount of amplification applied to an audio signal. Adjusting the gain of a frequency band includes raising or lowering the amplitude of the portion (e.g., frequency components) of the audio segment that corresponds to the frequency band. SPL module 208 sends gains 210 to audio output module 120 of equalization device 102 to apply a custom equalization setting based on the gains 210.

**Analyzing Sound Pressure Level**

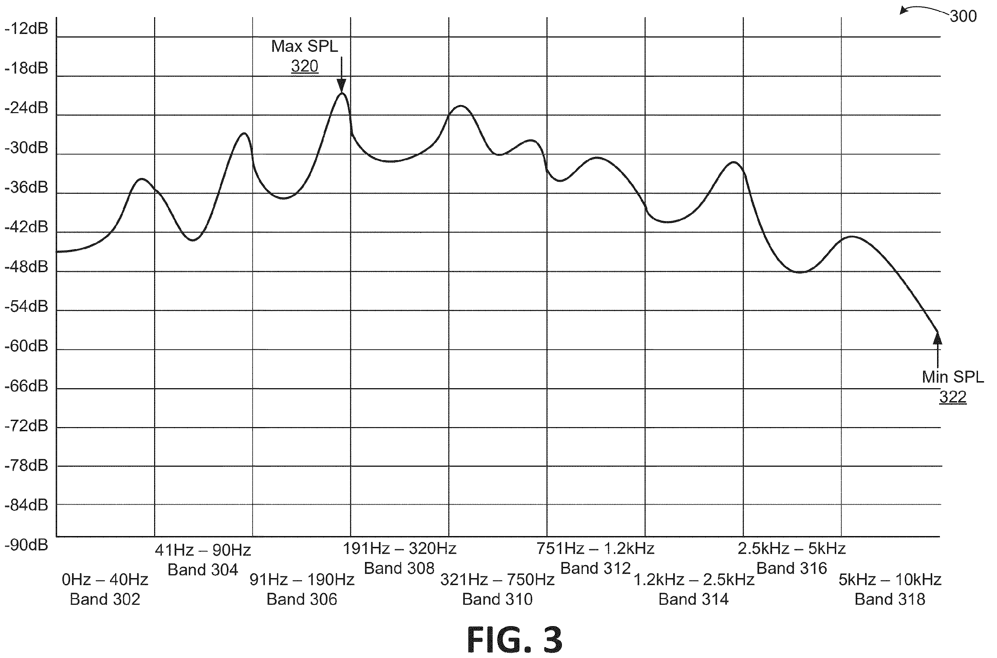

Figure 3 is a conceptual illustration of an exemplary frequency spectrum 300 of an audio segment, according to various embodiments. Frequency spectrum 300 is an example of a frequency spectrum that can be generated by frequency component module 204 of equalization manager 118 to help determine the SPL of each frequency component belonging to each frequency band of an audio segment. Using IDCT, frequency component module 204 can extract the frequency components of the audio segment to determine frequency spectrum 300. Frequency spectrum 300 is depicted in Figure 3 as a plot with frequency (in Hz) across the X-axis and amplitude (SPL in dB) across the Y-axis for an audio segment. Additionally, the X-axis is further broken up by frequency bands determined by frequency component module 204 of equalization manager 118. For example, Band 302 ranges from 0Hz - 40Hz, Band 304 ranges from 41Hz - 90Hz, Band 306 ranges from 91Hz - 190Hz, Band 308 ranges from 191Hz - 320Hz, Band 310 ranges from 321Hz - 750Hz, Band 312 ranges from 751Hz - 1.2kHz, Band 314 ranges from 1.2kHz - 2.5kHz, Band 316 ranges from 2.5kHz - 5kHz, and Band 318 ranges from 5kHz - 10kHz. Once the SPL of each frequency component belonging to each Band 302 - Band 318 is determined by SPL module 208 of equalization manager 118, SPL module 208 determines a maximum SPL and a minimum SPL of among all frequency components. For example, max SPL 320 in frequency spectrum 300, which has a value of around -20dB, represents the maximum SPL among all frequency components. Likewise, min SPL 322 in frequency spectrum 300, which has a value of around -58dB, represents the minimum SPL among all frequency components. SPL module 208 also determines the delta SPL between the maximum SPL and minimum SPL. For example, the delta SPL between max SPL 320 and min SPL 322 is around -38dB. SPL module 208 uses both max SPL 320 and the calculated delta SPL to calculate the gains for each frequency component of the audio segment. Frequency spectrum 300 can be output to user interface device 124 by equalization device 102 via input/output interface 106.

**Method of Automatically Updating Equalization Settings**

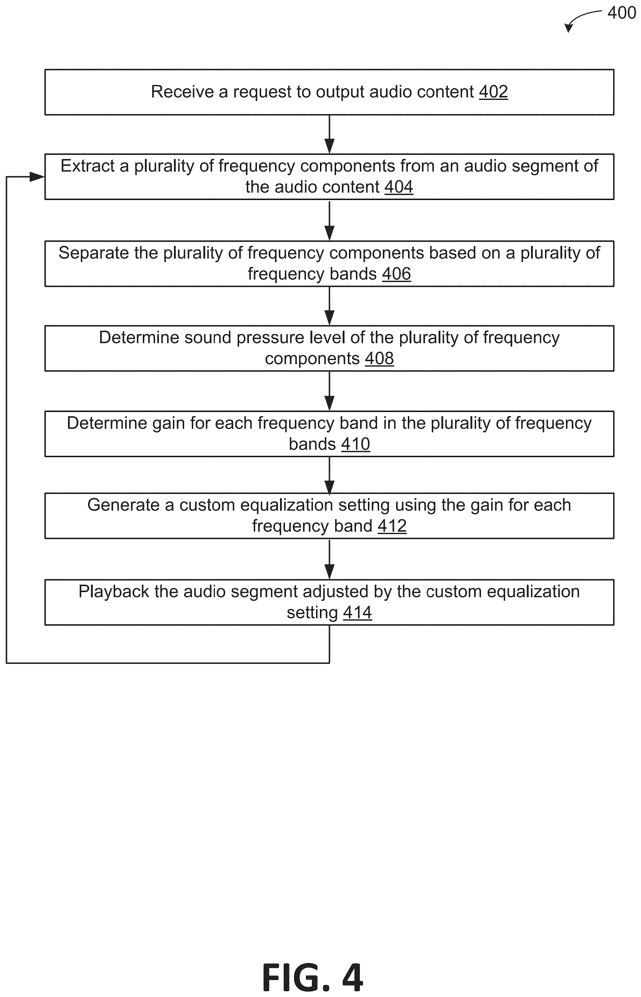

Figure 4 sets forth a flow diagram of method steps for automatically updating the equalization settings of an audio segment. Although the method steps are described with reference to the systems of Figures 1-3, persons skilled in the art will understand that any system configured to implement the method steps, in any order, falls within the scope of the present invention.

As shown, a method 400 begins at step 402, where equalization device 102 receives a request to output audio content. The audio content can be received from a user device, such user device 122 in Figure 1, via input/output interface 106. The audio content can be streamed audio data, such as a song from a streaming application, radio application, musical library, or any other source of audio streaming. If the audio is compressed, equalization device 102 can send the audio content to audio receiver 114 to decompress the audio content. After decompressing the audio content, audio receiver 114 sends each audio segment of the audio content to audio buffer 116 for storage as that audio segment is received.

At step 404, equalization manager 118 receives an audio segment and extracts a plurality of frequency components from the audio segment. Using IDCT, equalization manager 118 extracts a plurality of frequency components from the audio segment. Each frequency component can range from 0Hz - 20kHz within the frequency domain. For example, the frequency components in frequency spectrum 300 are within the range of 0Hz - 10kHz.

At step 406, equalization manager 118 separates the plurality of frequency components based on a plurality of frequency bands. For example, frequency component module 304 can separate the frequency components into nine frequency bands. For example, frequency spectrum 300 separates the frequency components of an audio segment into Band 302 which ranges from 0Hz - 40Hz, Band 304 which ranges from 41Hz - 90Hz, Band 306 which ranges from 91Hz - 190Hz, Band 308 which ranges from 191Hz - 320Hz, Band 310 which ranges from 321Hz - 750Hz, Band 312 which ranges from 751Hz - 1.2kHz, Band 314 which ranges from 1.2kHz - 2.5kHz, Band 316 which ranges from 2.5kHz - 5kHz, and Band 318 which ranges from 5kHz - 10kHz.. The frequency range of 10kHz - 20kHz comprises a single octave and is at the edge of the hearing ability of a human. Because most music contains audio signals below the 10kHz range, equalization manager 118 can determine to not include the frequency range of 10kHz - 20kHz in the frequency bands. For example, frequency bands Band 302 - Band 318, in frequency spectrum 300 only range from 0Hz - 10kHz. Frequency component module 204 can use any number of ranges, sub-ranges, and/or bands as necessary and the example above is not meant to be limiting in any way.

At step 408, equalization manager 118 determines the SPL for each frequency component belonging to the plurality of frequency bands. For example, equalization manager 118 can determine the SPL for each frequency component that belongs to the nine bands Band 302 - Band 318 in frequency spectrum 300. The SPL can be calculated using any technically feasible, such as Equation 1 above.

At step 410, equalization manager 118 determines a gain for each frequency band in the plurality of frequency bands. To determine the gain needed for each frequency band, equalization manager 118 determines the highest SPL among the frequency components, the lowest SPL among the frequency components, and the delta between the highest SPL and lowest SPL. Equalization manager 118 calculates the gain for each frequency band using any technically feasible algorithm, such as Equation 2 above. For example, max SPL 320 in frequency spectrum 300, which has a value of around -20dB, represents the maximum SPL among all frequency components. Likewise, min SPL 322 in frequency spectrum 300, which has a value of around -58dB, represents the minimum SPL among all frequency components. Equalization manager 118 can use max SPL 320 and min SPL 322 to determine the delta SPL between the maximum SPL and minimum SPL. For example, the delta SPL between max SPL 320 and min SPL 322 is around -38dB. Equalization manager can then use both max SPL 320 and the calculated delta SPL to calculate the gains for each frequency band. The gain for a particular frequency band represents an equalization setting for that particular frequency band. Gain is the amount of amplification applied to an audio signal. Adjusting the gain of a frequency band includes raising or lowering the amplitude of the portion (e.g., frequency components) of the audio segment that corresponds to the frequency band.

At step 412, equalization manager 118 generates a custom equalization setting for the audio segment based on the gain for each frequency band. In some embodiments, the gains for the frequency bands became the equalization setting. In some embodiments, the custom equalization setting is a best-fit setting. For example, audio output module 120 can determine from a set of pre-defined equalization settings, such as default Bass, Mid, Treble (BMT) settings, of an audio system, such as a vehicle sound system, a closest matching pre-defined equalization setting. The closest matching pre-defined equalization setting is the equalization setting in the set of pre-defined equalization settings whose frequency bands most closely matches the frequency components of the audio segment once the determined gains are applied. Audio output module 120 adjusts the audio segment by applying the custom equalization setting (e.g., applying the calculated gains to each of the frequency components corresponding to the different frequency bands determined by the equalization manager 118).

At step 414, audio output module 120 plays back the audio segment adjusted by the custom equalization settings to speakers 126 via input/output interface 106. The custom equalization setting is used during playback of the audio segment to provide a better listening experience. A notification when the custom equalization setting changes can be displayed by user interface device 124 via input/output interface 106. In some embodiments, audio output module 120 can delay the output of the audio segment for a pre-defined amount of time, such as 30 seconds, to allow for the next segment of audio to be analyzed by equalization device 102.

As discussed above and further emphasized here, Figure 4 is merely an example which should not unduly limit the scope of the claims. One of ordinary skill in the art would recognize many variations, alternatives, and modifications. In some embodiments, equalization manager 118 does not determine the gains and the equalization settings for each audio segment of the audio content. In some examples, the equalization settings determined from one segment is used to adjust the audio for other audio segments, such as for the rest of a current song, until the user provides an indication that the equalization settings should be updated, and/or the like. In such scenarios, step 414 is repeated for the additional audio segments before returning to step 404.

In sum, the disclosed techniques automatically change the audio equalization levels of audio based on the audio being played. When an audio content is requested for playback, the equalization manager of an audio system extracts the frequency components of a segment of the audio content. The equalization manager analyzes the frequency components of the segment and separates the frequency components into predefined frequency bands based on the analysis. The equalization manager determines sound pressure level (SPL) metrics of each frequency component. The equalization manager determines the gains for each frequency band based on the SPL metrics of each frequency component. The equalization manager generates a custom equalization setting using the gains for each frequency band based on the SPL metrics of each frequency component. The equalization manager then adjusts the audio segment by applying the custom equalization setting to generate a modified segment (e.g., applying the calculated gains to each of the frequency bands determined by the equalization manager). The modified segment is then output as audio to a user. The process then repeats for additional segments of the audio.

At least one technical advantage of the disclosed techniques relative to the prior art is that the disclosed techniques allow for automatically changing audio equalization levels based on the audio being played in automobiles. By automatically changing the audio equalization levels, drivers of automobiles no longer have an extra distraction while still being able to have a quality listening experience. Furthermore, because the change in equalization levels is automatic and not manual, extensive knowledge of the musical composition of the audio and/or underlying audio engineering is not required. Additionally, because the audio equalization levels change based on the audio being played, the audio system is not constricted to a few default BMT settings that might not encompass the desired breadth of customization. These technical advantages provide one or more technological improvements over prior art approaches.

1. In some embodiments, a computer-implemented method for automatically updating equalization settings of audio segments comprising receiving audio content for playback; extracting a plurality of frequency components from a first segment of the audio content; separating the plurality of frequency components into a plurality of first frequency bands; determining a sound pressure level (SPL) for each frequency component in the plurality of frequency components; determining, based on the SPL of each frequency component in the plurality of frequency components, a gain for each frequency band in the plurality of first frequency bands; generating, based on the gain for each frequency band in the plurality of first frequency bands, a first equalization setting; adjusting, based on the first equalization setting, the first segment to generate a modified segment; and outputting the modified segment using one or more speakers.

2. The computer-implemented method of clause 1, wherein extracting the plurality of frequency components from the first segment comprises performing inverse discrete cosine transformations on the first segment of the audio content.

3. The computer-implemented method of any of clauses 1-2, wherein the audio content is streaming audio content.

4. The computer-implemented method of any of clauses 1-3, wherein determining the gain for each frequency band in the plurality of first frequency bands further comprises determining a highest SPL among the plurality of frequency components; determining a lowest SPL among the plurality of frequency components; determining a delta SPL, wherein the delta SPL is a difference between the highest SPL and the lowest SPL; and determining, based on the SPL of a second frequency band in the plurality of first frequency bands, the highest SPL, and the delta SPL, a gain for the second frequency band.

5. The computer-implemented method of any of clauses 1-4, wherein determining the SPL for each frequency component in the plurality of frequency components comprises determining the SPL relative to a reference SPL.

6. The computer-implemented method of any of clauses 1-5, wherein extracting the plurality of frequency components of the first segment of audio content comprises decoding the audio content; and segmenting the audio content into a plurality of audio segments, wherein the first segment of audio is in the plurality of audio segments.

7. The computer-implemented method of any of clauses 1-6, further comprising adjusting, based on the first equalization setting, one or more second segments of the audio content to generate one or more second modified segments; and outputting the one or more second modified segment using one or more speakers.

8. The computer-implemented method of clause 7, wherein the one or more second segments are remaining segments of a song forming the audio content.

9. The computer-implemented method of any of clauses 1-8, wherein generating the first equalization setting further comprises determining a second equalization settings from a plurality of third equalization settings, the second equalization setting having a best fit to the gains for the plurality of frequency bands; and selecting the second equalization setting as the first equalization setting.

10. The computer-implemented method of any of clauses 1-9, wherein generating the first equalization setting further comprises using the gains for the plurality of first frequency bands as the first equalization setting.

11. The computer-implemented method of any of clauses 1-10, further comprising outputting the equalization setting to a user interface device.

12. The one or more non-transitory computer-readable media of clause 11, further comprising extracting a second plurality of frequency components from a second segment of the audio content; separating the second plurality of frequency components a plurality of second frequency bands; determining an SPL for each frequency component in the second plurality of frequency components; determining, based on the SPL of each frequency band in the second plurality of frequency components, a second gain for each frequency band in the plurality of second frequency bands; generating, based on the gain for each frequency band in the plurality of second frequency bands, a second equalization setting; adjusting, based on the second equalization setting, the second segment to generate a second modified segment; and outputting the second modified segment using one or more speakers.

13. In some embodiments, one or more non-transitory computer-readable media including instructions that, when executed by one or more processors, cause the one or more processors to perform the steps of receiving audio content for playback; extracting a plurality of frequency components from a first segment of the audio content; separating the plurality of frequency components into a plurality of first frequency bands; determining a sound pressure level (SPL) for each frequency component in the plurality of frequency components; determining, based on the SPL of each frequency component in the plurality of frequency components, a gain for each frequency band in the plurality of first frequency bands; generating, based on the gain for each frequency band in the plurality of first frequency bands, a first equalization setting; adjusting, based on the first equalization setting, the first segment to generate a modified segment; and outputting the modified segment using one or more speakers.

14. The one or more non-transitory computer-readable media of clause 13, wherein the audio content is streaming audio content.

15. The one or more non-transitory computer-readable media of any of clauses 13-14, wherein the step of determining the gain for each frequency band in the plurality of first frequency bands further comprises determining a highest SPL among the plurality of frequency components; determining a lowest SPL among the plurality of frequency components; determining a delta SPL, wherein the delta SPL is a difference between the highest SPL and the lowest SPL; and determining, based on the SPL of a second frequency band in the plurality of first frequency bands, the highest SPL, and the delta SPL, a gain for the second frequency band.

16. The one or more non-transitory computer-readable media of any of clauses 13-15, wherein the step of determining the SPL for each frequency component in the plurality of frequency components comprises determining the SPL relative to a reference SPL.

17. The one or more non-transitory computer-readable media of any of clauses 13-16, wherein the instructions, when executed by one or more processors, further cause the one or more processors to perform the step of adjusting, based on the first equalization setting, one or more second segments of the audio content to generate one or more second modified segments; and outputting the one or more second modified segment using one or more speakers.

18. The one or more non-transitory computer-readable media of any of clauses 13-17, wherein the step of generating the first equalization setting further comprises determining a second equalization settings from a plurality of third equalization settings, the second equalization setting having a best fit to the gains for the plurality of frequency bands; and selecting the second equalization setting as the first equalization setting.

19. The one or more non-transitory computer-readable media of any of clauses 13-18, wherein the step of generating the first equalization setting further comprises using the gains for the plurality of first frequency bands as the first equalization setting.

20. In some embodiments, a system comprises one or more memories storing instructions and one or more processors coupled to the one or more memories that, when executing the instructions, perform the steps of receiving audio content for playback; extracting a plurality of frequency components from a first segment of the audio content; separating the plurality of frequency components into a plurality of first frequency bands; determining a sound pressure level (SPL) for each frequency component in the plurality of frequency components; determining, based on the SPL of each frequency component in the plurality of frequency components, a gain for each frequency band in the plurality of first frequency bands; generating, based on the gain for each frequency band in the plurality of first frequency bands, a first equalization setting; adjusting, based on the first equalization setting, the first segment to generate a modified segment; and outputting the modified segment using one or more speakers.

Any and all combinations of any of the claim elements recited in any of the claims and/or any elements described in this application, in any fashion, fall within the contemplated scope of the present invention and protection.

The descriptions of the various embodiments have been presented for purposes of illustration, but are not intended to be exhaustive or limited to the embodiments disclosed. Many modifications and variations will be apparent to those of ordinary skill in the art without departing from the scope and spirit of the described embodiments.

Aspects of the present embodiments may be embodied as a system, method or computer program product. Accordingly, aspects of the present disclosure may take the form of an entirely hardware embodiment, an entirely software embodiment (including firmware, resident software, micro-code, etc.) or an embodiment combining software and hardware aspects that may all generally be referred to herein as a "module," a "system," or a "computer." In addition, any hardware and/or software technique, process, function, component, engine, module, or system described in the present disclosure may be implemented as a circuit or set of circuits. Furthermore, aspects of the present disclosure may take the form of a computer program product embodied in one or more computer readable medium(s) having computer readable program code embodied thereon.

Any combination of one or more computer readable medium(s) may be utilized. The computer readable medium may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples (a nonexhaustive list) of the computer readable storage medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain, or store a program for use by or in connection with an instruction execution system, apparatus, or device.

Aspects of the present disclosure are described above with reference to flowchart illustrations and/or block diagrams of methods, apparatus (systems) and computer program products according to embodiments of the disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine. The instructions, when executed via the processor of the computer or other programmable data processing apparatus, enable the implementation of the functions/acts specified in the flowchart and/or block diagram block or blocks. Such processors may be, without limitation, general purpose processors, special-purpose processors, application-specific processors, or field-programmable gate arrays.

The flowchart and block diagrams in the figures illustrate the architecture, functionality, and operation of possible implementations of systems, methods and computer program products according to various embodiments of the present disclosure. In this regard, each block in the flowchart or block diagrams may represent a module, segment, or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts, or combinations of special purpose hardware and computer instructions.

While the preceding is directed to embodiments of the present disclosure, other and further embodiments of the disclosure may be devised without departing from the basic scope thereof, and the scope thereof is determined by the claims that follow.

## Claims

1. A computer-implemented method for automatically updating equalization settings of audio segments, the method comprising:

    receiving audio content for playback;
    extracting a plurality of frequency components from a first segment of the audio content;
    separating the plurality of frequency components into a plurality of first frequency bands;
    determining a sound pressure level (SPL) for each frequency component in the plurality of frequency components;
    determining, based on the SPL of each frequency component in the plurality of frequency components, a gain for each frequency band in the plurality of first frequency bands;
    generating, based on the gain for each frequency band in the plurality of first frequency bands, a first equalization setting;
    adjusting, based on the first equalization setting, the first segment to generate a modified segment; and
    outputting the modified segment using one or more speakers.

2. The method of claim 1, wherein extracting the plurality of frequency components from the first segment comprises performing inverse discrete cosine transformations on the first segment of the audio content.

3. The method of claim 1 or 2, wherein the audio content is streaming audio content.

4. The method of any of claims 1 to 3, wherein determining the gain for each frequency band in the plurality of first frequency bands further comprises:

    determining a highest SPL among the plurality of frequency components;
    determining a lowest SPL among the plurality of frequency components;
    determining a delta SPL, wherein the delta SPL is a difference between the highest SPL and the lowest SPL; and
    determining, based on the SPL of a second frequency band in the plurality of first frequency bands, the highest SPL, and the delta SPL, a gain for the second frequency band.

5. The method of any of claims 1 to 4, wherein determining the SPL for each frequency component in the plurality of frequency components comprises determining the SPL relative to a reference SPL.

6. The method of any of claims 1 to 5, wherein extracting the plurality of frequency components of the first segment of audio content comprises:

   decoding the audio content; and
   segmenting the audio content into a plurality of audio segments, wherein the first segment of audio is in the plurality of audio segments.

7. The method of any of claims 1 to 6, further comprising:

   adjusting, based on the first equalization setting, one or more second segments of the audio content to generate one or more second modified segments; and
   outputting the one or more second modified segment using one or more speakers.

8. The method of claim 7, wherein the one or more second segments are remaining segments of a song forming the audio content.

9. The method of any of claims 1 to 8, wherein generating the first equalization setting further comprises:

   determining a second equalization settings from a plurality of third equalization settings, the second equalization setting having a best fit to the gains for the plurality of frequency bands; and
   selecting the second equalization setting as the first equalization setting.

10. The method of any of claims 1 to 9, wherein generating the first equalization setting further comprises:
    using the gains for the plurality of first frequency bands as the first equalization setting.

11. The method of any of claims 1 to 10, further comprising:
    outputting the equalization setting to a user interface device.

12. The method of any of claims 1 to 11, further comprising:

    extracting a second plurality of frequency components from a second segment of the audio content;
    separating the second plurality of frequency components a plurality of second frequency bands;
    determining an SPL for each frequency component in the second plurality of frequency components;
    determining, based on the SPL of each frequency band in the second plurality of frequency components, a second gain for each frequency band in the plurality of second frequency bands;
    generating, based on the gain for each frequency band in the plurality of second frequency bands, a second equalization setting;
    adjusting, based on the second equalization setting, the second segment to generate a second modified segment; and
    outputting the second modified segment using one or more speakers.

13. One or more non-transitory computer-readable media including instructions that, when executed by one or more processors, cause the one or more processors to perform the steps of:

    receiving audio content for playback;
    extracting a plurality of frequency components from a first segment of the audio content;
    separating the plurality of frequency components into a plurality of first frequency bands;
    determining a sound pressure level (SPL) for each frequency component in the plurality of frequency components;
    determining, based on the SPL of each frequency component in the plurality of frequency components, a gain for each frequency band in the plurality of first frequency bands;
    generating, based on the gain for each frequency band in the plurality of first frequency bands, a first equalization setting;
    adjusting, based on the first equalization setting, the first segment to generate a modified segment; and
    outputting the modified segment using one or more speakers.

14. The one or more non-transitory computer-readable media of claim 13, wherein the audio content is streaming audio content.

**15.** A system comprising:

one or more memories storing instructions; and
one or more processors coupled to the one or more memories that, when executing the instructions, perform the steps of:

receiving audio content for playback;
extracting a plurality of frequency components from a first segment of the audio content;
separating the plurality of frequency components into a plurality of first frequency bands;
determining a sound pressure level (SPL) for each frequency component in the plurality of frequency components;
determining, based on the SPL of each frequency component in the plurality of frequency components, a gain for each frequency band in the plurality of first frequency bands;
generating, based on the gain for each frequency band in the plurality of first frequency bands, a first equalization setting;
adjusting, based on the first equalization setting, the first segment to generate a modified segment; and
outputting the modified segment using one or more speakers.

FIG. 1

EP 4 761 281 A1

Equalization Manager 118

Audio Segment
202
→
Frequency
Component
Module
204
→
Frequency
Components
206
→
Sound Pressure
Level (SPL)
Module
208
→
Gains
210

EP 4 761 281 A1

**FIG. 2**

**FIG. 3**

400

Receive a request to output audio content 402

Extract a plurality of frequency components from an audio segment of the audio content 404

Separate the plurality of frequency components based on a plurality of frequency bands 406

Determine sound pressure level of the plurality of frequency components 408

Determine gain for each frequency band in the plurality of frequency bands 410

Generate a custom equalization setting using the gain for each frequency band 412

Playback the audio segment adjusted by the custom equalization setting 414

# FIG. 4

Europäisches Patentamt

European Patent Office

Office européen des brevets

# EUROPEAN SEARCH REPORT

**Application Number**

EP 25 21 8596

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 104 811 155 A (SHENZHEN GRANDSUN ELECTRONIC CO LTD) 29 July 2015 (2015-07-29) * the whole document * | 1-15 | INV. H04R3/00 H04R3/04 H03G5/00 H03G5/02 H03G5/16 |
| X | CN 113 163 298 A (SHENZHEN 3NOD DIGITAL SCIENCE & TECH CO LTD) 23 July 2021 (2021-07-23) * the whole document * | 1-15 | |
| X | CN 117 376 778 A (SHENZHEN BLUETRUM TECH CO LTD) 9 January 2024 (2024-01-09) * the whole document * | 1-15 | |
| A | US 2021/092539 A1 (TU PO-JEN [TW] ET AL) 25 March 2021 (2021-03-25) * the whole document * | 1-15 | |
| A | EP 3 160 158 A1 (MARVELL WORLD TRADE LTD [BB]) 26 April 2017 (2017-04-26) * the whole document * | 1-15 | **TECHNICAL FIELDS SEARCHED (IPC)** |
| A | WO 2020/017732 A1 (SAMSUNG ELECTRONICS CO LTD [KR]) 23 January 2020 (2020-01-23) * the whole document * | 1-15 | H04R H03G |

The present search report has been drawn up for all claims

| Place of search | Date of completion of the search | Examiner |
|---|---|---|
| Munich | 6 April 2026 | Sucher, Ralph |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 21 8596

This annex lists the patent family members relating to the patent documents cited in the above-mentioned European search report.
The members are as contained in the European Patent Office EDP file on
The European Patent Office is in no way liable for these particulars which are merely given for the purpose of information.

06-04-2026

| Patent document cited in search report | | Publication date | Patent family member(s) | | Publication date |
|---|---|---|---|---|---|
| CN 104811155 | A | 29-07-2015 | NONE | | |
| CN 113163298 | A | 23-07-2021 | NONE | | |
| CN 117376778 | A | 09-01-2024 | NONE | | |
| US 2021092539 | A1 | 25-03-2021 | TW | 202114349 A | 01-04-2021 |
| | | | US | 2021092539 A1 | 25-03-2021 |
| EP 3160158 | A1 | 26-04-2017 | CN | 106604179 A | 26-04-2017 |
| | | | EP | 3160158 A1 | 26-04-2017 |
| | | | JP | 7056884 B2 | 19-04-2022 |
| | | | JP | 2017123636 A | 13-07-2017 |
| | | | US | 2017111737 A1 | 20-04-2017 |
| WO 2020017732 | A1 | 23-01-2020 | NONE | | |

EPO FORM P0459

For more details about this annex : see Official Journal of the European Patent Office, No. 12/82